# EUROPEAN PATENT APPLICATION

(11) **EP 4 818 687 A1**
(43) Date of publication of application: **07.10.2026**
(21) Application number: 25315120.3
(22) Date of filing: 04.04.2025
(51) Int. Cl.: G01N 24/00, G01B 7/14, G01R 33/26

(54) **DEVICE FOR OPTICALLY DETECTED MAGNETIC RESONANCE WITH LIFT-OFF DISTANCE MEASUREMENT**

(71) Applicant: Kwan-Tek, 56270 Ploemeur (FR)
(72) Inventor: Hingant, Thomas, 35000 Renne (FR)
(74) Representative: Yes My Patent

(57) **Abstract**

According to an aspect, the present invention relates to a sensor head, a device and a method for determining a magnetic field parameter and a distance between the sensor head and an item, the sensor head comprising at least:
- An objective (50) comprising a nitrogen-vacancy center doped diamond (40) adapted to produce a fluorescence in response to a first light, wherein the first light is chosen so as to excite the nitrogen-vacancy centers;
- a light-guiding component (41a) configured to guide said first light to said diamond and at least part of the fluorescence collected from the diamond;
wherein the objective (50) is positioned between the light-guiding component (41a) and the item,
and wherein the diamond is designed to receive a second light from the light-guiding component, transmit the second light to the item facing the diamond, and collect at least part of the reflected second light for transmission back to the light-guiding component (41a).

## Description

### Technical field

The present disclosure concerns a device for magnetic field sensing with lift-off distance measurement. The device may be applied for example in the field of non-destructive testing.

### Background

Magnetic field sensing with NV centers in diamond can be carried out using an appropriately doped diamond, for example by using optically detected magnetic resonance (ODMR) for measuring a magnetic field. Applications of magnetic field sensing with NV centers in diamond are manifold - the compactness of the sensor head may be an important criterion for certain non-destructive testing applications. Scanning techniques in non-destructive testing, including ODMR, are usually sensitive to the lift-off distance, i.e. the distance between the sensor and the item to test. This is for example the case for measurements of eddy currents or of stray magnetic fields.

It is hence desirable to propose a compact sensor head for magnetic field sensing with NV centers that allows measurement of the lift-off distance.

### Summary

The present technology has been designed to overcome at least some drawbacks present in prior art solutions.

According to a first aspect, the present invention relates to a sensor head for measuring, preferably simultaneously, a magnetic field and a distance between the sensor head and an item, the sensor head comprising at least:
- An objective comprising a nitrogen-vacancy center doped diamond adapted to produce a fluorescence in response to a first light, wherein the first light is chosen so as to excite the nitrogen-vacancy centers;
- a light-guiding component configured to guide said first light to said diamond and at least part of the fluorescence collected from the diamond;

wherein the objective is positioned between the light-guiding component and the item,
and wherein the diamond is designed to receive a second light from the light-guiding component, transmit the second light to the item facing the diamond, and collect at least part of the reflected second light for transmission back to the light-guiding component.

According to another aspect, the present invention relates to a device for measuring, preferably simultaneously, a magnetic field and at least one distance between a sensor head according to the present invention and an item, the device comprising
- said sensor head;
- a first source of the first light;
- a second source of the second light;
- said device being configured to inject the first and second lights into the light-guiding component of the sensor head, said device further comprising:
   o a first detector for detecting red fluorescence produced by the diamond of the sensor head in response to the first light;
   o a second detector for detecting second light reflected by an item under test placed in front of the sensor head;
   o a signal processor for obtaining a measurement of a magnetic field responsive to the detected red fluorescence and a measurement of a distance between the diamond and the item responsive to the reflected second light.

According to another aspect, the present invention relates to a computer-implemented method for determining, preferably simultaneously, a magnetic field parameter and a distance between a sensor head according to the present invention and an item, the method being configured to be executed by the device according to the present invention, the method comprising at least:
a. A collecting phase comprising the following steps:
   i. Excitation of at least one nitrogen-vacancy center in a diamond using a first source emitting a first light;
   ii. Illuminating at least partially the item using a second source emitting a second light;
   iii. Delivering a microwave signal via a microwave antenna using a microwave generation unit to induce an optically detected magnetic resonance in the nitrogen-vacancy diamond;
   iv. Collecting nitrogen-vacancy photoluminescence and at least a fraction of the reflected second light via the optical fiber;
b. A measuring phase comprising at least the following steps executed in any order:
   i. Measuring the nitrogen-vacancy photoluminescence using at least a first photodetector to get at least one photoluminescence signal;
   ii. Measuring the fraction of the reflected second light using a second photodetector or a spectrophotometer to get at least one distance signal related to the distance between the sensor head and the item;
c. An analyzing phase comprising at least the following steps executed in any order:
   i. Analyzing the distance signal to get the distance between the sensor head and the item using a first processing unit.
   ii. Analyzing the photoluminescence signal to get magnetic field information from the item using a second processing unit.
d. A determining phase comprising at least the following steps executed in any order:
   i. Determining the distance between the sensor head and the item from the distance signal using the first processing unit;
   ii. Determining at least one value of at least one parameter of the magnetic field from the magnetic field information using the second processing unit.

According to an example, the invention can be used for example for eddy current measurements, stray field measurements, or Barkhausen noise measurements.

According to another aspect, the present invention relates to a computer product program for determining, preferably simultaneously, a magnetic field parameter and a distance between a sensor head of a device according to the present invention and an item, which, when executed by at least one processing unit, executes the method according to the present invention.

According to another aspect, the present invention relates to a non-transitory computer readable medium comprising at least one computer program product according to the present invention.

Before providing below a detailed review of embodiments of the technology, some optional characteristics that may be used in association or alternatively will be listed hereinafter:

According to an example, the present invention further comprises a microwave antenna configured to provide a microwave magnetic field to said diamond.

According to an example, the second light is a polychromatic light and the diamond acts as a chromatic dispersive optical element, the chromatic dispersion caused by the diamond being sufficient for allowing a confocal chromatic measurement of a distance between the diamond and the item.

According to an example, the diamond comprises a diffractive lens surface on the path of the second light.

According to an example, the present invention comprises a gradient-index lens arranged between the light-guiding component and the diamond.

According to an example, the second light is a laser light and said objective is configured for one among: focusing the second light on the surface of the item; or collimating the second light for illuminating the item.

According to an example, the present invention further comprises an actuator responsive to a control signal function of the measured distance.

According to an example, the signal processor is further configured to apply a feedback loop to the actuator to dynamically adjust the distance between the sensor head and the item under test, based on the measurement of the distance obtained from the reflected second light.

According to an example, the first light source is a laser emitting in the green spectral range, and the second light source is a white light source configured to provide chromatic dispersion-based distance measurement.

According to an example, the first detector is a photodetector configured to analyze optically detected magnetic resonance signals from the fluorescence of the nitrogen-vacancy diamond, and the second detector is a spectrophotometer configured to measure the spectral shift of the back-reflected second light for stand-off distance control.

According to an example, the second light source is a laser source configured to generate a coherent beam for interferometric detection, and the second detector is an interferometric photodetector configured to analyze phase shifts in the back-reflected second light to achieve sub-nanometer precision in distance measurement.

According to an example, the signal processor comprise a first processing unit and a second processing unit, the first processing unit being configured to analyzing a distance signal to obtain the measurement of a distance between the diamond and the item, and the second processing unit being configured to analyze a photoluminescence signal to obtain the measurement of a magnetic field.

According to an example, the second photodetector comprises an interferometric photodetector.

According to an example, the present invention further comprises, after the determining phase, an adjusting phase comprising adjusting the sensor head position relatively to the item using a actuator based on the value of the parameter of the magnetic field and and/or the determined distance.

### Brief description of the figures

Example embodiments will be more fully understood from the detailed description provided herein and the accompanying drawings, which are given by way of illustration only.
FIG. 1 is a schematic representation of a diamond crystal and its carbon atoms (C), and comprising a nitrogen atom (N) and a vacancy (V), the latter two forming an 'NV center';
FIG. 2 is a schematic diagram of the energy levels of an NV center;
FIG. 3 is a graph of ODMR (Optically Detected Magnetic Resonance) data obtained by measuring the red fluorescence for different magnetic field values;
FIG. 4 is a schematic block diagram of the components of an exemplary NV magnetometer comprising a sensor head and an excitation/readout/processing unit;
FIG. 5 is a schematic diagram of a sensor head according to one or more exemplary embodiments;
FIG. 6 is a schematic block diagram of a sensor head according to an exemplary first embodiment;
Fig. 7 is a graph representing a phase profile of a kinoform lens that can be used in conjunction with the first embodiment;
Fig. 8 is a schematic diagram of a sensor head with a refocusing component;
Fig. 9 is a through-focus spot diagram of a system using the sensor head illustrated by Fig. 8;
Fig. 10 is a schematic block diagram of an exemplary second embodiment.
Fig. 11 is a schematic block diagram of the exemplary first embodiment.
Fig. 12 is a schematic block diagram of the exemplary second embodiment.
Fig. 13 is a flowchart illustrating steps of a method according to an embodiment of the present invention.

Various exemplary embodiments will now be described more fully with reference to the accompanying drawings. However, specific structural and functional details disclosed herein are merely representative for purposes of describing example embodiments. The exemplary embodiments may be embodied in many alternate forms and should not be construed as limited to only the embodiments set forth herein. It should be understood that there is no intent to limit example embodiments to the particular forms disclosed.

It should be appreciated by those skilled in the art that any functions, engines, block diagrams, flow diagrams, state transition diagrams and / or flowcharts herein represent conceptual views of illustrative circuitry embodying the principles of the exemplary embodiments. Functions, actions or steps described herein can be implemented in hardware or software or any combination thereof. If implemented in software, the functions, blocks of the block diagrams and/or flowchart illustrations can be implemented e.g. using software code executed by a processor or a processing device.

In the present description, functional blocks denoted as "means configured to perform ..." a certain function shall be understood as functional blocks comprising circuitry that is adapted for performing or configured to perform a certain function. A means being configured to perform a certain function does, hence, not imply that such means necessarily is performing said function (at a given time instant). Moreover, any entity described herein as "means", may be implemented as one or more distinct entities or within an entity providing additional functions. When provided by a processor, the functions may be provided by a single processor or several processors. Moreover, the term "processor" includes one or more of a digital signal processor, remote 'cloud' processor, graphical processing units, dedicated or generic circuitry, read only memory for storing software, random access memory, and non-volatile storage.

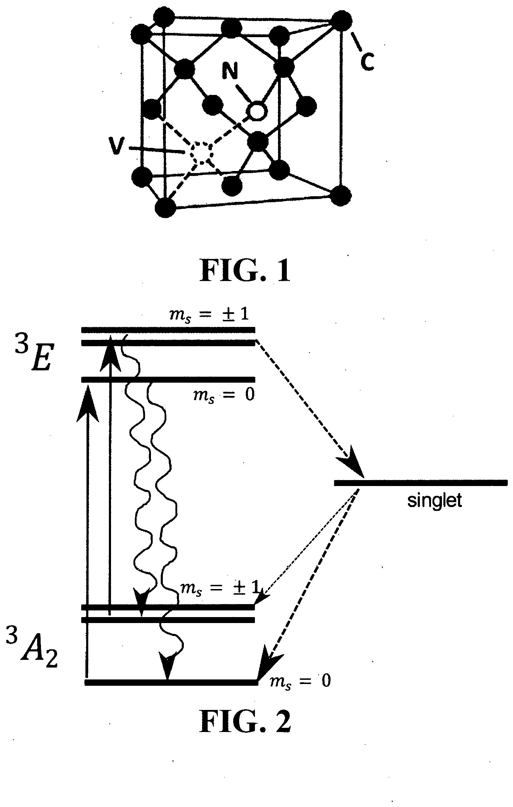

NV magnetometry is based on the use of a particular defect of the diamond crystal lattice in the solid state. The term NV (Nitrogen-Vacancy) center refers to the substitution of a carbon atom by a nitrogen atom, directly adjacent to a lattice vacancy (a missing carbon atom), as shown in FIG. 1. This defect presents energy levels and various interesting physical characteristics, which can be used in a magnetic field sensor. These measurements can also be used to determine temperatures, electric fields, strains and pressure. In particular, when a NV diamond crystal (containing millions of NV centers) is irradiated with green light (e.g. coming from a laser or a LED), it fluoresces red light with an intensity generally proportional to the irradiation.

FIG. 2 is a schematic diagram of the energy levels of the NV center, and showing the ground state triplet state 3A2, the excited triplet state 3E and the singlet state. Owing to quantum mechanical selection rules, when the NV center is in the ms = 0, respectively ms = ± 1 state, in the ground state, it tends to stay in the ms = 0, respectively ms = ± 1, state when absorbing a green photon from the excitation light source, as shown by the two upward oriented straight arrows. Similar selection rules apply when the NV center is de-excited from the excited state to the ground state by the emission of a red fluorescence photon, as shown by the two downward oriented wobbly arrows. However, when the NV center lands in the ms = ± 1 levels in the excited state, it has a larger (about 7 times) probability to decay non radiatively in the singlet state than when in the ms = 0 excited state. From the singlet state, the NV center returns preferentially (with twice larger probability) to the ms = 0 ground state. As a result, the NV center can be optically polarized in the ms = 0 ground state through the application of green excitation light. Red fluorescence is emitted owing to the radiative decay from the excited state to the ground state. This level of fluorescence varies depending on the initial spin level of the NV center in the ground state: more fluorescence is recorded when the NV center is initially in the ms = 0 spin level than in the ms = ± 1 levels, owing to the non-radiative transitions through the singlet state in the second case.

A microwave field with a frequency around 2.87 GHz can be applied to change the spin state of the NV center in its ground state from ms = 0 to ms = 1 or ms = -1. When the frequency of the microwave field is resonant with the energy level difference, less red fluorescence is observed. This phenomenon is called Optically Detected Magnetic Resonance ('ODMR').

A magnetic field lifts the degeneracy between the ms . = 1 and ms = -1 levels. Therefore, when a magnetic field is applied to the NV center, two frequencies for which the fluorescence decreases can be observed, linearly related to the magnitude of the magnetic field: ${f}_{res} = 2.87 GHz \pm \frac{γ}{2 π} B$ (Eq. 1)
where B is the magnetic field aligned with the axis of the NV center (i.e. the axis defined by the alignment of the nitrogen atom and the gap) and γ is the gyromagnetic ratio of the NV center: *γ*/ 2*π*=28 GHz/T.

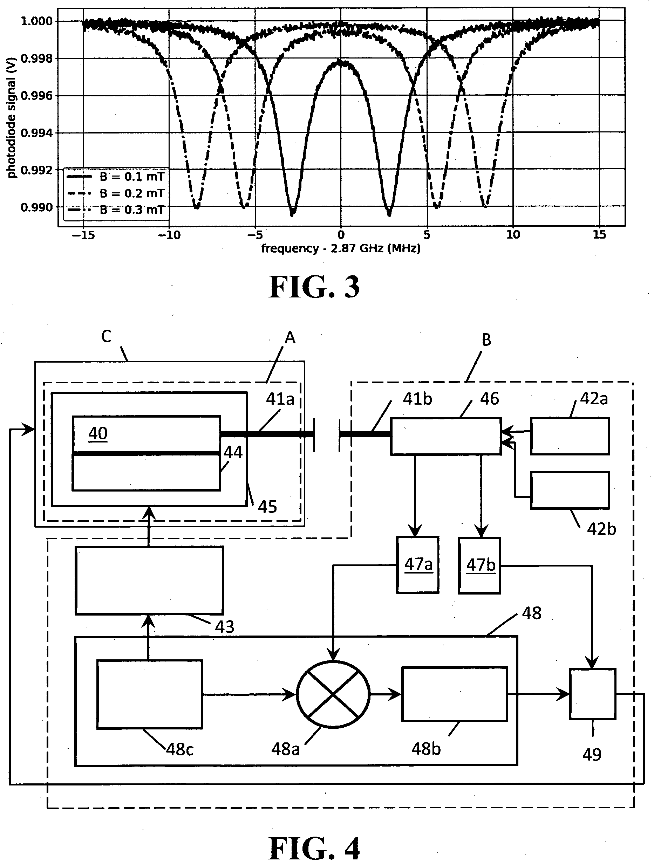

FIG. 3 is a graph of simulated ODMR data that can be obtained by measuring the red fluorescence for different magnetic field values. For each value of the magnetic field, the two resonance dips in the photodiode output signal and centered around the excitation frequency appear clearly. The spacing of the dips increases with the intensity of the magnetic field. Since the NV centers can exist in four different directions within the crystal, a total of four pairs of two resonances can actually be observed, each pair corresponding to a projection of the magnetic field vector onto a given direction of an NV axis. This allows to univocally identify the three spatial components of the magnetic field, and thus to obtain a vector measurement of the latter. The NV sensor allows an accurate vector measurement of a magnetic field, with a good sensitivity: the latter is often limited by the photon shot noise of the fluorescence light, reaching typical values ranging from pT/ √ Hz to nT/ √ Hz depending on the sensor design.

As described hereafter, and according to an embodiment, the present invention relates to a sensor head for measuring, preferably simultaneously, a magnetic field and a distance between the sensor head and an item. Preferably, the sensor head integrates at least one nitrogen-vacancy (NV) center doped diamond as part of an objective, preferably as an optical element of an objective. Advantageously, this objective is configured to produce fluorescence in response to an excitation light, called hereafter first light, which ideally stimulates the NV centers within the diamond. The NV centers are known for their sensitivity to magnetic fields and their capability of producing distinct fluorescence outputs, which serves as a signal when detecting magnetic field variations. The present invention is preferably configured to ensure that the diamond remains strategically positioned between a light-guiding component, guiding the excitation light, i.e. called the first light, and the item being measured, optimizing the interaction between the excitation light and the NV centers to enhance the measurement sensitivity and resolution. Advantageously, the present invention is configured to maintain efficient optical alignment and maximize the signal-to-noise ratio during the detection process.

According to an embodiment, the light-guiding component not only directs the first light to the diamond to excite the NV centers but also facilitates the collection, at least partially, of fluorescence emitted by the NV centers for analysis. By positioning the objective to receive and transmit a second light to the item being measured, the present invention can effectively support simultaneous measurements of both magnetic fields and distances from the diamond to the item. Advantageously, the second light refers to a laser or polychromatic light that is directed towards the item being measured, enabling distance measurement through reflection and/or spectral analysis.

According to an embodiment, the sensor head can further comprise a microwave antenna. This microwave antenna is preferably configured to provide a microwave magnetic field specifically to the diamond containing the NV centers. Advantageously, this microwave field is configured to induce optically detected magnetic resonance (ODMR) within the NV centers, which enhances their sensitivity to external magnetic fields. The resonance condition allows the NV centers to efficiently absorb and later emit light, producing a measurable fluorescence. The ability to actively manipulate the resonance conditions using the microwave antenna optimizes the detection of subtle variations in magnetic field parameters, thereby increasing the sensor's operational versatility and robustness.

According to an embodiment, the magnetic field parameters can comprise at least one of the following parameters: amplitude, norm, frequency, orientation vector, and/or phase.

Furthermore, the antenna's microwave field is configured to improve the interaction with the NV centers, resulting in a higher level of fidelity in detecting magnetic field variations. This not only enables a more precise magnetic field measurement but also enhances the efficiency of the overall sensing mechanism.

According to an embodiment, the second light is a polychromatic light. Preferably, the diamond's interaction with the polychromatic light enables the present invention to achieve confocal chromatic measurements of distances between the diamond and the item. The chromatic dispersion caused by the diamond's properties leads to a separation of different wavelengths of the light, allowing for precise distance measurements as varying wavelengths correlate to different distance values.

Preferably, the integration of this chromatic dispersion functionality with the existing elements, such as the NV centers, provides a synergistic effect. The distance measurements derived from polychromatic light not only complement the magnetic field data obtained from the NV centers but also contribute to a comprehensive sensing solution.

According to an embodiment, the diamond can comprise at least one diffractive lens surface. Preferably, the use of a diffractive lens surface on the diamond enhances the optical functionalities within the sensor head. This surface is specifically designed to manipulate the path of the second light, ensuring optimal interaction with both the diamond and the item being measured. The presence of this diffractive lens allows for the conversion of light forms, facilitating improved signal collection and enhancing the quality of the reflected light that returns to the light-guiding component. Additionally, the diffractive surface contributes to perform confocal distance measurements adeptly, ensuring resolution and accuracy. Preferably, the diffractive surface allows for tuning the chromatic dispersion of the objective.

Preferably, by optimizing the second light path, the diffractive lens complements the functionality of the NV centers in terms of fluorescence production and detection efficiency. These features are configured to harmonize the two types of measurement (magnetic field and distance), allowing the sensor to function seamlessly across different measurement modalities.

According to an embodiment, the sensor head can further comprise a gradient-index lens. This gradient-index lens is preferably positioned strategically between the light-guiding component and the diamond. Advantageously, this gradient-index lens is configured to refine the optical performance of the sensor head. By varying the refractive index across the lens, it effectively focuses or collimates the light entering the diamond without introducing significant distortion or aberrations. The gradient-index lens enhances the present invention's efficiency, ensuring the optimal illumination conditions are maintained.

According to an embodiment, the second light source can be a laser. This allows the sensor head to utilize coherent illumination to enhance measurement effectiveness. The use of laser light, particularly for the second light, can, for example, increase the energy density and directs the illumination neatly on the item being assessed. This capability to either focus on or collimate the light allows for measuring distance with interferences and achieve high accuracy: Additionally, this can also allow for high-quality illumination that can be useful in distinguishing fine details in distance measurement and improving the resolution of reflected signals.

According to an embodiment, and as described hereafter, the present invention relates to a device for measuring, preferably simultaneously, a magnetic field and/or a distance between the sensor head and an item.

Preferably, the device comprises the sensor head alongside dedicated light sources, detectors, and a signal processor, providing an integrated solution for simultaneous magnetic field and distance measurement. This multi-component configuration allows for streamlined operations where first (excitation) and second (measuring) lights are effectively injected into the sensor head, ensuring a synchronized interaction with the NV centers. For example, the presence of specialized detectors for both fluorescence and reflected light provides a dual-channel performance that can accurately capture the multitude of data necessary for analysis, allowing the present invention to operate effectively in complex environments.

Advantageously, the signal processor is configured to translate the optical signals obtained from detectors into meaningful measurements. This processing step ensures that the output data from the NV centers directly correlates with magnetic field parameters while, preferably simultaneously, deriving accurate distance readings from the reflected second light. This synergistic approach enhances the device's capability to provide real-time feedback on magnetic and spatial parameters.

According to an embodiment, the device further comprise at least one actuator. Preferably, the actuator is configured to respond to control signals dependent on the measured distance. This actuator can facilitate dynamic adjustments to the sensor head's position concerning the item being measured, allowing for optimized measurement conditions. This real-time feedback loop promotes a responsive device that can adapt to variations in object positioning, ensuring that the sensor maintains optimal positions and measurement accuracy while simultaneously tracking magnetic field changes.

Advantageously, the device is configured to automatically correct the sensor head's positioning, ensuring precise detection and analysis of both magnetic fields and distances. This active control allows to add a layer of adaptability and accuracy to the measurement, minimizing errors associated with static positions.

According to an embodiment, the first light source can be a laser emitting in the green spectral range, while the second light source is a white light source, i.e. polychromatic source. Combining a first light source that emits in the green spectral range with a second light source configured as a white light source utilizes spectral properties effectively for measurement purposes. The green laser light for the first source is configured to excite the NV centers, maximizing fluorescence yield and, consequently, enhancing sensitivity in magnetic field measurements. Meanwhile, the white light source is specially configured to facilitate chromatic dispersion, yielding reliable distance measurements based on light wavelength studies. This dual approach caters to both aspects of the sensing functionalities, providing a versatile and calibrated setup for operational efficacy.

According to an embodiment, and as described hereafter, the first detector can comprise a photodetector configured to analyze magnetic resonance signals from the NV diamond. Preferably, the second detector can comprise a spectrophotometer for measuring spectral shifts of reflected second light.

Advantageously, these two detectors are configured to cooperate: while the first detector is tasked primarily with capturing the nuanced fluorescence signaling magnetic field variations, the second detector focuses on determining distance through careful spectral analysis. Together, they create a comprehensive analytical framework that supports simultaneous measurements, reinforcing the underlying benefit of this multifaceted device.

According to another embodiment, the second light source can also be a laser, and the second detector can comprise an interferometric photodetector. The.use of a coherent laser source for the second light and the use of an interferometric photodetector is configured to enhance the device capabilities. This arrangement allows for advanced interferometric detection capabilities, enabling precise phase shift analysis in the back-reflected light. By utilizing the coherent properties of the laser, this setup ensures that phase changes can be detected, allowing for sub-nanometer precision in distance measurements - an impressive and invaluable attribute in scientific research and practical applications demanding high accuracy.

FIG. 4 is a block diagram of the components of a non-limiting exemplary embodiment of an NV magnetometer shown with the purpose of describing various components used therein. The device of FIG. 4 comprises two subsystems: a sensor head A and an excitation/readout/processing module B. In the device of FIG. 4, the same fiber is used both to carry the excitation light for the NV diamond and to collect the resulting fluorescence emitted by NV centers. However, according to other embodiments described later on, distinct fibers can be used to perform each of these functions.

According to the example of FIG. 4, the sensor head A comprises an NV diamond 40, an optical fiber 41a and a bias magnet 45. The magnetic bias may be provided to allow resolution of the different magnetic resonances. It may for example be a permanent magnet. A typical value of the bias field is around 10 mT, but this value is given purely as a non-limiting example. Other types of sources of a continuous magnetic field, such as a coil, micro Helmholtz coils or a Halbach array may also be used. Sensor head A also comprises a microwave resonator 44. The resonator ensures a sufficiently strong coupling between the NV electronic spins and a microwave magnetic field provided by a microwave source 43. As a non-limiting example, microwave magnetic field amplitudes of a few 10⁻⁴ T can typically be used. Depending on the application, the resonator can be for example a printed circuit board-based resonator or broadband antenna, or a wire antenna made with copper. As necessary, sensor head A also comprises a substrate and/or mechanical components e.g. a housing for holding the diamond, the microwave resonator, the optical fiber and the magnet.

According to one embodiment, the excitation/readout/processing module B comprises a green light source 42a. This light source 42a may be a laser or a LED, for example with a power in the range 1 - 100 mW at the wavelength in the range 510 - 550 nm and stabilized in power to ensure low enough relative intensity noise (RIN) level. Module B further comprises a microwave source 43, the tunable frequency of which is around 2.87 GHz, coupled to microwave resonator 44. The microwave source is driven by a local oscillator 48c.

Module B also comprises a separator 46. One function of separator 46 is used to separate the red fluorescence emitted by the NV centers and having a wavelength at around 650 nm from the light received through fibers 41a and 41b and provide it to a photodetector 47a. Component 41b may also be a lightguide other than an optical fiber. The red fluorescence produced by the NV centers is collected and travels in the optical fiber, in the opposite direction compared to that of the green excitation light provided by source 42. The red light separator function can be provided a dichroic optical element or any optical system that can isolate the red fluorescence. Photodetector 47a (e.g. a photodiode) is used to detect the red light received as output from separator 46 and for providing a corresponding signal at its output. The photodetector can be used in conjunction with a transimpedance amplifier (not shown) to generate a voltage based on the photodetector output and to feed the next stage.

Module B also comprises a lock-in amplifier 48. The lock-in amplifier receives the signal from the photodetector 47a and its associated amplification means. The lock-in amplifier comprises a mixer 48a and a low-pass filter 48b. The mixer 48a is driven by local oscillator 48c, which according to one non-limiting embodiment is part of the lock-on amplifier. A processor 49 may advantageously be located remotely compared to the sensor head A. It acquires and processes the information provided by the lock-in amplifier. It is also used to control a user interface for communication with the user. The processor executes software code stored in a memory (not shown).

The sensor head A and the excitation/readout/processing module B are connected through a connector (not shown), the role of which is to optically connect the modules A and B through fibers 41a and 41b.

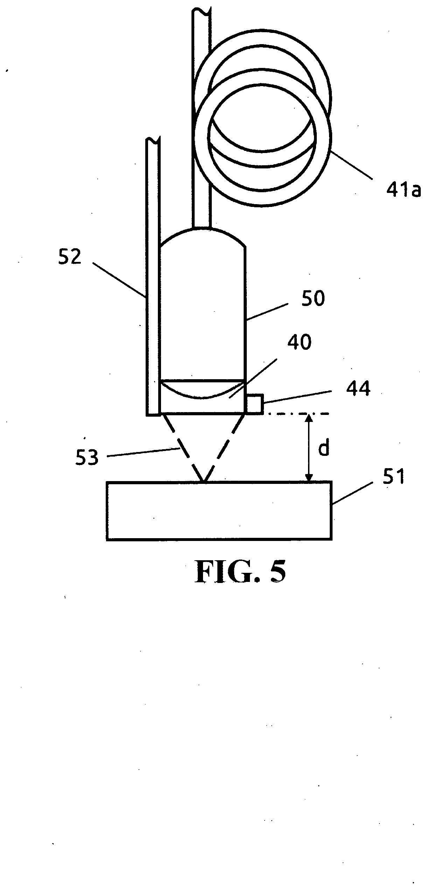

Figure 5 is a schematic diagram of a sensor head A according to one or more embodiments. Sensor head A comprises an objective 50 which optically connects NV diamond 40 and fiber 41a so as to, on one hand, achieve a good illumination of the NV diamond with the green laser excitation light, and on the other hand, collect fluorescence emitted by the NV centers and channel it through the fiber to module B. Diamond 40 is placed at the extremity of the objective which faces item 51 being tested. In the example of Fig. 5, microwave antenna 44 is illustrated as being fixed to one side of the diamond, although it can be placed at any appropriate location.

Substrate 52 is part of a housing for protecting the different components of the sensor head and maintaining them in place. Only part of the housing is shown in Fig. 5. Diamond 40 is also part of the optical system for the measurement of the lift-off distance 'd'. The transparent nature of the diamond is used to allow illumination of the surface of item 51 through diamond 40 with an appropriate light, the reflection of which on the surface of item 51 back towards the objective 50 being used to derive a measurement of distance d. The nature of the light and the measurement technique depends on the embodiment. The combined use of the diamond both as part of the magnetic field measurement subsystem and of the lift-off distance measurement subsystem allows a co-localized measurement of both physical quantities and hence a compact sensor head. Once the lift-off distance is obtained, it can be used e.g. in the processing of the magnetic field measurements and/or to derive a control signal for driving an actuator to the limit lift-off distance within a certain range or keep it substantially constant.

A first embodiment implements a confocal chromatic measurement of the lift-off distance. A second embodiment implements a measurement based on interferometry.

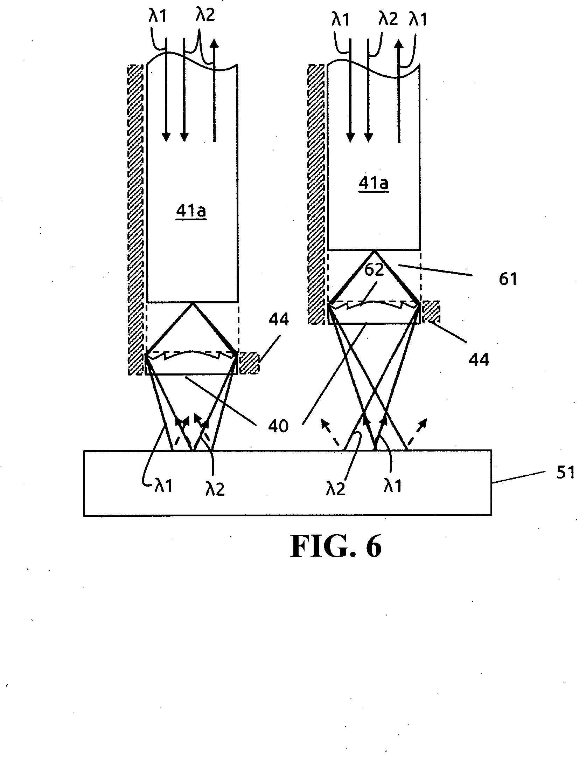

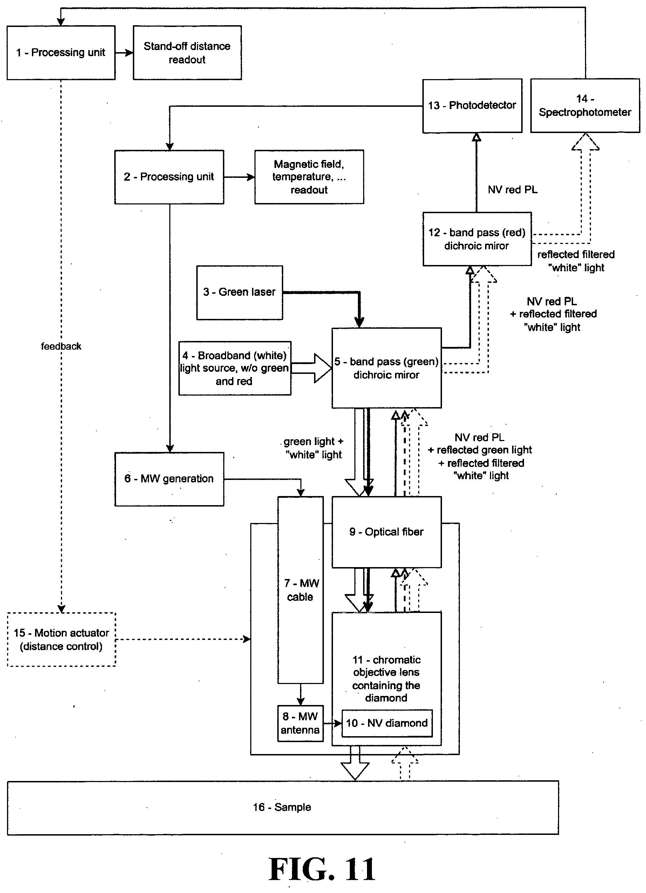

Confocal chromatic measurement is a technique, known per se, for non-contact profilometry. The principle is to focus polychromatic light on a item with a strongly chromatic objective. Because of the strong chromatism, the distance of focus is dependent on the wavelength. The light is reflected, collected by the objective and coupled to the optical fiber. The spectrum of the back-reflected light is indicative of the distance of the object - indeed, the wavelength of maximum power corresponds to the wavelength for which the focus distance is equal to the distance to the item. Other wavelengths are defocused and hence dampened in the signal coupled back to the optical fiber. Figures 6 and 11 relates to this first embodiment. Indeed, figure 6 is a schematic block diagram of a sensor head, and Figure 11 is a more detailed schematic block diagram of a sensor head, according to the first embodiment. In the example of Fig. 6, sensor head A is presented at two different lift-off distances from item 51. In order to simplify the diagrams, the diamond 40 and the fiber 41a have the same diameter, but in practice, objective 50 may be used to illuminate a diamond with an optical fiber of smaller or bigger diameter compared to the dimensions of the diamond. The same diamond is used both for magnetometry and as the final optical element of the objective focusing polychromatic light on the item for the confocal chromatic distance measurement. The polychromatic light may for example be white light. The light is focused on the item under test through the diamond, and the part of the light which is reflected back is collected through the same path. Because the system has a strong chromatic dispersion, the reflected light is efficiently coupled into the same fiber only at a precise wavelength. This wavelength is function of the lift-off distance. For example, in FIG.6 the dispersion is engineered so that at a short lift-off distance, light at λ1 is out of focus while light at λ2 is focused on the item and back-reflected into the fiber. Conversely, at a larger lift-off, light at λ1 is focused on the item and back-collected while light at λ2 is not coupled back in the fiber. The determination of this wavelength of maximum power in the reflected light, using e.g. a spectrophotometer, thus allows determining the lift-off distance.

Optionally, a spacer 61 can be placed between the optical fiber 41a and diamond 40. This is the case in the embodiment illustrated in Fig. 6.

According to an embodiment, the spacer is designed to have optical power, such as a gradient-index lens. This means that the spacer itself can be configured to contribute to the overall optical performance of the system. By incorporating a gradient-index lens, the spacer can manipulate the light path, focusing or collimating the beam as needed. This approach allows for a more compact and efficient optical design, as the spacer plays an active role in shaping the light. The optical power of the spacer can be finely tuned to achieve the desired focal length and beam quality, enhancing the overall performance of the objective. This method is particularly useful in applications where space is limited, and high precision is required. The integration of an optically powered spacer ensures that the system can achieve the necessary focusing and collimation without relying solely on the diamond or other optical elements.

According to another embodiment, the spacer is transparent but does not have any optical power. This could be a glass or air spacer, or even the absence of a spacer altogether. In this embodiment, the optical power can come from the diamond itself, which may be designed with a Fresnel lens or other optical features to achieve the necessary focusing, for example. The transparent spacer serves to maintain the physical separation between components without altering the light path. This approach relies on the diamond's optical properties to achieve the desired performance. By using a Fresnel lens, the diamond can focus the light effectively, ensuring that the system remains compact and efficient. This method is advantageous in situations where the spacer's primary function is to provide structural support rather than contribute to the optical performance. The reliance on the diamond for optical power ensures that the system can achieve high precision and accuracy in its measurements.

According to another embodiment, the diamond can be encapsulated in a substrate that has optical power, such as a silica substrate. This approach combines the benefits of both the diamond and the substrate, creating a highly efficient optical system. The substrate can provide additional focusing or collimation, enhancing the overall performance of the objective. By encapsulating the diamond in an optically powered substrate, the system can achieve better control over the light path, reducing aberrations and improving image quality. This method is particularly useful in applications where high precision and stability are required. The combination of the diamond and the substrate allows for a more versatile and robust optical design, capable of handling a wide range of wavelengths and intensities. This approach ensures that the system can achieve the necessary optical performance while maintaining the structural integrity and durability of the components.

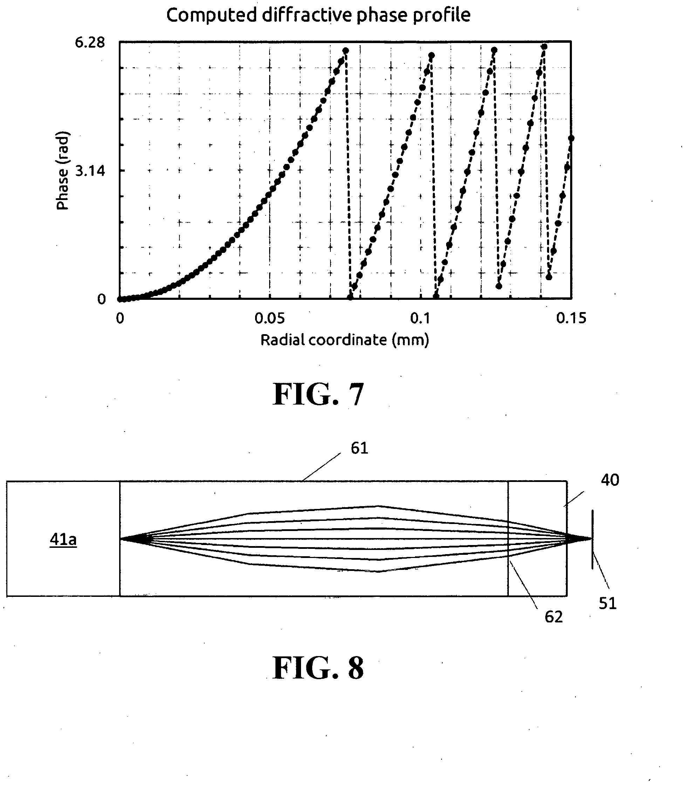

According to a variant embodiment, the chromatic dispersion of the diamond is enhanced by adding a diffractive lens surface on its top surface facing the objective or optical fiber. The surface of the diamond is for example shaped as a kinoform lens 62. Fig. 7 presents a phase profile of a kinoform lens according to a non-limiting embodiment. The profile may be generated using for example lithography, with steps of e.g. 10 nm width.

According to an embodiment, the objective can derive its power from various elements, including the diamond. This comprehensive approach ensures that the optical system is not solely reliant on the fiber for its functionality. By integrating different components, such as the diamond, the objective can achieve enhanced performance and versatility. The diamond, known for its exceptional optical properties, contributes significantly to the overall power and efficiency of the objective. Its unique characteristics, such as high refractive index and thermal conductivity, make it an asset in the optical design. This integration allows for better control and manipulation of light, leading to improved precision and accuracy in various applications. Consequently, the objective, with its multifaceted sources of power, stands as a robust and reliable component in advanced optical systems.

The use of the diamond along with a diffractive lens surface allows for a very strongly dispersive, and thus very compact system. The diffractive surface can act on its own as a focusing element or optionally be supplemented with an additional optical refocusing component in order to ensure proper optical coupling with the optical fiber. Such a refocusing component can be added e.g. in the context of small lift-off distances (such as 200 µm). A non-limiting example of a sensor head including a refocusing component in the frame of the first embodiment is provided in Fig. 8, where the refocusing component 61 is a gradient-index ('GRIN') lens. The refocusing component 61 also acts as spacer. As a non-limiting illustrative example, diamond 40 of Fig. 7 is 1 mm wide and 0.25 mm thick.

According to an embodiment, the objective is the complete optical assembly, comprising the diamond. In the case where a refocusing element is desired, the diamond is stroked with an already convergent beam so that the focusing of the polychromatic part on the item is close to the diamond. This approach ensures that the optical system maintains its integrity and precision, allowing for accurate and efficient focusing. By using a convergent beam, the system can achieve a higher degree of control over the focal point, which is useful for experiments requiring high precision.

According to an example, the diamond, being a component of the optical assembly, benefits from this method as it minimizes potential distortions and aberrations that could arise from a less focused beam. Consequently, this technique enhances the overall performance of the optical system, making it more reliable and effective for various applications.

Figure 11 describes an optoelectronic architecture that integrates multiple optical and microwave components to enable high-precision sensing and feedback-controlled positioning, according to the first embodiment.

We will now describe this architecture in detail according to Figure 11.

According to an embodiment, the optical system of the present invention is configured to excite and detect photoluminescence from NV centers in the diamond sensor. Preferably, the optical system comprises at least:
a. A laser 3, advantageously green, configured to emit light used for optical excitation of NV centers. The laser beam is directed through a beam path to the NV diamond 10.
b. Broadband Light Source 4, advantageously white, configured to act as a secondary light source emitting a broadband spectrum (excluding the wavelength of the laser 3, and preferably green and red) assists in spectral analysis and distance measurement.

According to an embodiment, these optical sources are coupled into the optical system through a series of dichroic mirrors that selectively transmit or reflect specific wavelengths:
a. A first Band Pass Dichroic Mirror 5: Allows transmission of the laser beam, preferably green, while reflecting the other wavelengths.
b. A second Band Pass Dichroic Mirror 12: Permits selective passage of NV photoluminescence (preferably NV red photoluminescence) while filtering out unwanted spectral components.

According to an embodiment, the optical signal interacts with the chromatic objective lens 11, which focuses the excitation light onto the NV diamond 10. The diamond 10, acting as the primary quantum sensor, is mounted in close proximity to the item 16, which may contain magnetic features to be analyzed.

According to an embodiment, the photoluminescence emitted by the NV centers, along with reflected broadband light, is then guided through an optical fiber 9 to a spectrophotometer 14 and a photodetector 13 for spectral decomposition and intensity measurement.

According to an embodiment, the present invention uses microwave excitation to manipulate NV electron spin states. Preferably, this can be achieved through at least:
a. A microwave generation unit 6 configured to produce the required microwave signals at frequencies corresponding to NV spin transitions.
b. A microwave cable 7 configured to transport the microwave signal from the generator to the antenna.
c. A microwave antenna 8 configured to deliver the microwave field directly to the NV diamond 10 for coherent spin manipulation.

Preferably, the interaction between optical and microwave excitations allows for detection of magnetic field variations by analyzing shifts in the ODMR spectrum.

According to an embodiment, the present invention allows to measure and regulate the stand-off distance between the NV diamond 10 and the item 16. Preferably, this can be achieved through at least:
a. A processing unit for distance readout 1 configured to analyze chromatic dispersion effects from the broadband light source to determine the lift-off distance.
b. A actuator 15 configured to adjusts the position of the NV diamond relative to the item in real-time, based on feedback from the distance processing unit.

Preferably, the lift-off distance measurement is facilitated by the chromatic objective lens 11, which introduces wavelength-dependent focal shifts, enabling micron precision in distance estimation, for example.

According to an embodiment, the present invention comprises a dual-processing architecture:
a. A processing unit for magnetic field readout 2 configured to analyzes ODMR spectral shifts to extract information about the local magnetic field, and advantageously temperature, near the NV diamond.
b. The processing unit for distance readout 1 which is dedicated to analyzing optical signals for real-time distance measurement.

Preferably, both units are interconnected to provide real-time feedback control, ensuring accurate sensor positioning and compensation for environmental fluctuations. According to an embodiment, a global processing unit can comprise the processing unit for distance readout 1 and the processing unit for magnetic field readout 2.

According to an embodiment, the present invention can execute the following workflow:
a. The laser 3, preferably green, excites the NV centers in the diamond 10, and broadband light 4 illuminates the item for chromatic distance measurement.
b. The microwave generation unit 6 delivers a controlled signal via the microwave antenna 8 to induce ODMR in the NV diamond 10.
c. NV red photoluminescence and reflected white light are collected via optical fiber 9 and analyzed by the spectrophotometer 14 and photodetector 13.
d. The magnetic field and lift-off distance are extracted by respective processing units 1 and 2.
e. Based on detected signals, the actuator 15 dynamically adjusts the NV diamond position to maintain optimal sensor performance.

Advantageously, the present invention provides a highly integrated solution for precision quantum sensing with built-in optical distance feedback. The combination of ODMR, chromatic distance sensing, and closed-loop feedback control enables robust and highly sensitive measurements for applications in various fields.

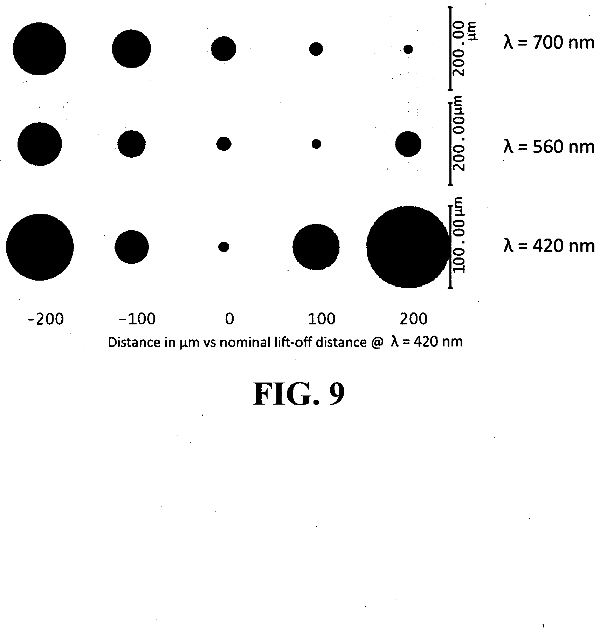

Fig. 9 is a through-focus spot diagram of a system using the sensor head illustrated by Fig. 8. The diagram shows the spot size (ordinate scale provided in µm) at three wavelengths (420 nm, 560 nm, 700 nm) and for different lift-off distances compared to a central position at '0' (abscissa) for the wavelength of 420 nm. This central position corresponds to the smallest or best focus for the wavelength of 420 nm (i.e. the wavelength with the highest power in the reflected light signal) - the nominal lift-off distance optimized for this wavelength lies 200 µm away from the diamond surface. The diagram also shows that when the smallest focus spot is detected for a wavelength of 700 nm, the lift-off distance is 200 µm greater than for the 420 nm wavelength. For a 200 µm nominal lift-off distance, a 50% change in the lift-offs is in principle measurable.

Coming back to Fig. 4, as an example of combined implementation of both OMDR and confocal chromatic lift-off measurement, module B comprises a second light source, labelled 42b. Light source 42b is used in conjunction with the lift-off distance measurement functionality of the system. Within the frame of the first embodiment described above, the light produced by light source 42b is polychromatic light, for example white light. The light produced by light source 42b is injected into optical fibers 41b and 41a to illuminate the item under test, and the light reflected by the item under test is retrieved through separator 46 and analyzed using spectrophotometer 47b. The results are processed by processor 49 for determining the lift-off distance measurement as a function of the peak power wavelength identified in the spectrophotometer signal.

Optionally, the lift-off distance measurement is used to control the lift-off distance. For this purpose, the system shown in Fig. 4 comprises an actuator C fixed to sensor head A. Actuator C is controlled by processor 49 and is for example a precision linear actuator that allows positioning sensor head A along a direction perpendicular to the plane on which the item under test is to be placed. Processor 49 is configured to keep the lift-off distance for example at a substantially constant value. Processor 49 may implement a PID controller.

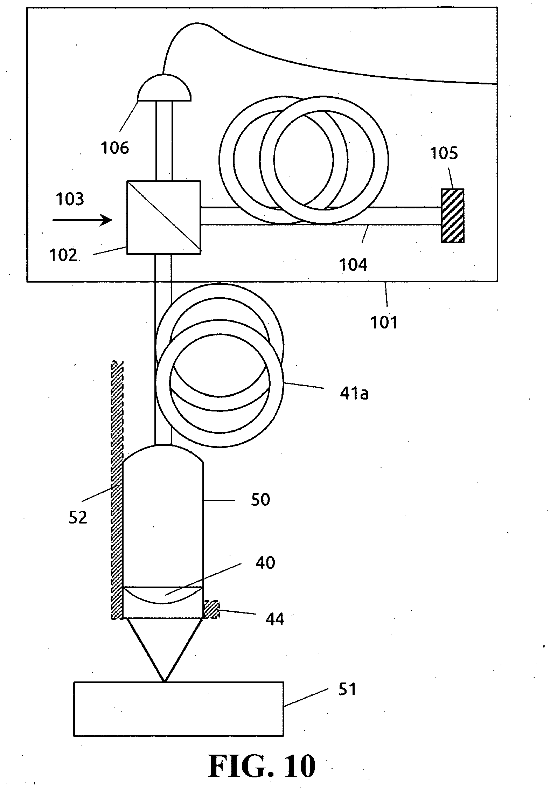

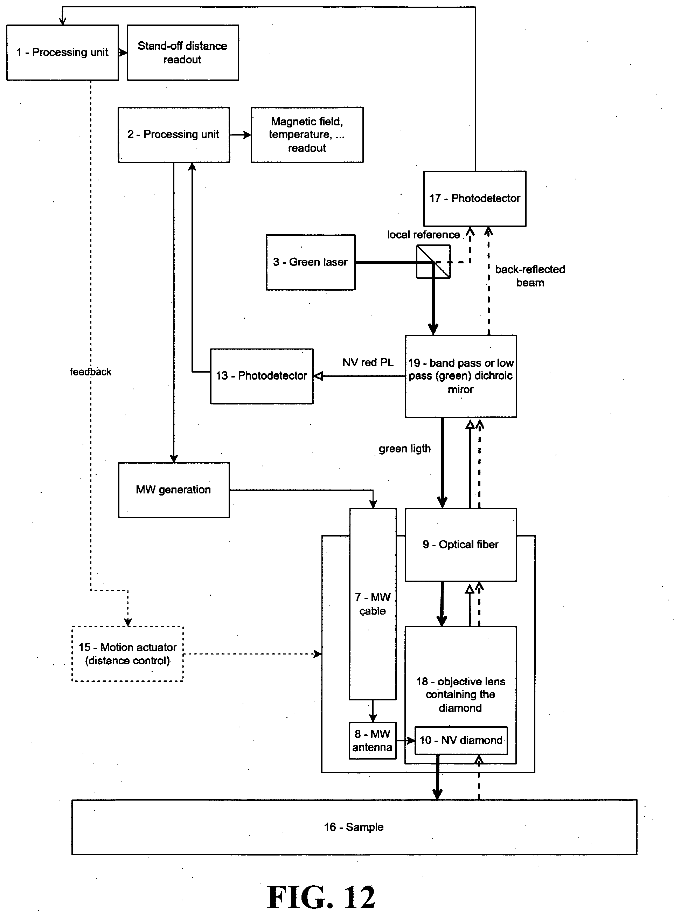

According to a second embodiment and as illustrated by figures 10 and 12,, the lift-off distance is obtained using an interferometric measurement setup. Fig. 10 is a schematic block diagram of an exemplary device comprising a sensor head A as shown in Fig. 5 and components of module B relevant for lift-off distance measurement using a Michelson interferometer subsystem 101. This subsystem comprises a beam splitter 102 for receiving laser light 103. The laser light reflected by the beam splitter follows a sample path along fiber 41a towards item 51 and is reflected back towards beam splitter 102. The laser light passing through beam splitter 102 follows a reference path along fiber 104, is reflected by mirror 105 and travels back towards beam splitter 102. After recombination of the two beams at the beam splitter, interferences are observed by detector 106. In a fashion known per se, the interference signal depends on the phase difference between the reference path and the samplepath, phase difference which depends on the lift-off distance d. The signal from detector 106 can be processed by processor 49 to determine the lift-off distance. For interferometric measurement, the beam sent to item 51 can be either focused on the surface of the item, or collimated. According to an embodiment, the diamond plays a role in the optical design of the lens, as it is an integral part of the collimation system. This collimation can be directly related to the optical power of the diamond, which depends advantageously on its thickness and/or the adaptation of its surfaces. For example, the use of a diffractive surface, such as a kinoform, can improve the chromatic dispersion of the diamond, thus enabling a more compact and efficient optical system. By integrating the diamond into the lens, better illumination and fluorescence collection can be achieved, which is useful for precise measurements.

As with the first embodiment, the lift-off distance measurement can optionally be used to control the distance using actuator C.

Figure 12 describes an optoelectronic architecture that integrates multiple optical and microwave components to enable high-precision sensing and feedback-controlled positioning, according to the second embodiment.

We will now describe this architecture in detail according to Figure 12.

According to an embodiment, the present invention comprises an integrated optical, microwave, and feedback control architecture that ensures precise and accurate detection of optically detected magnetic resonance signals while maintaining an optimal lift-off distance between the NV diamond and the item.

According to an embodiment, the present invention is configured to excite the NV centers in a diamond 10 and detect the emitted photoluminescence for quantum sensing applications. Preferably, the optical components of the present invention can comprise at least:
a. A laser 3, preferably green laser, is configured to be a monochromatic laser source that provides excitation energy for the NV centers. The laser light, preferably green, is directed towards the NV diamond 10 through an optical path.
b. An objective lens containing the diamond (18), preferably a precision optical assembly housing the NV diamond 10. This lens is configured to focus the excitation beam onto the NV diamond and to collect emitted NV photoluminescence, preferably red.
c. A band-pass or low-pass dichroic mirror 19 configured to filter selectively transmits the laser light, preferably green, to the NV diamond while blocking other wavelengths, ensuring efficient optical excitation.
d. A photodetector 13 configured to capture the NV photoluminescence, preferably red, emission, which carries encoded information about local magnetic fields variations, and for example, temperature variations.

Preferably, the present invention uses these optical components in conjunction with an interferometric distance measurement sub-system, described hereafter, to ensure that the NV sensor is positioned at an optimal stand-off distance for high-fidelity quantum measurements.

According to an embodiment, and in order to manipulate the spin states of NV centers for ODMR sensing, the present invention comprises a microwave excitation module. Preferably, the microwave excitation module comprises at least:
a. A microwave generation unit configured to produce microwave signals at predetermined resonance frequencies to drive the NV spin transitions.
b. A microwave cable 7 configured to transport the generated microwave signal to a microwave antenna.
c. The microwave antenna 8 configured to radiate the microwave field onto the NV diamond 10, inducing transitions in the electronic spin states of the NV centers.

According to an embodiment, the present invention comprises an interferometric back-reflection sub-system for stand-off distance measurement. This interferometric back-reflection sub-system is configured to enable real-time monitoring and control of the NV diamond's position relative to the item 16. Preferably, the interferometric back-reflection sub-system comprises at least:
a. A photodetector for local reference 17 configured to capture the back-reflected beam from the optical path. The interference pattern formed by this reflection provides preferably high-resolution distance information.
b. A back-reflected beam path configured to be used to leverage the principle of phase differences in the reflected light to determine the exact position of the NV diamond 10 relative to the item 16.
c. A processing unit for stand-off distance readout 1 configured to analyze the interferometric data and extract the precise distance measurement.

Preferably, by continuously monitoring the back-reflected optical signal, the interferometric sub-system allows for precise feedback control of the NV diamond's positioning.

According to an embodiment, the present invention comprises two processing units configured to work together to optimize both the ODMR-based sensing and the interferometric distance measurement. Preferably, the present invention comprises at least:
a. A processing unit for magnetic field readout 2, and optionally for temperature readout. The processing unit for magnetic field readout 2 is configured to process the ODMR spectral data obtained from the NV photoluminescence, preferably red, detected by photodetector 13. It advantageously extracts valuable information about the local magnetic field, temperature, for example.
b. A processing unit for stand-off distance readout 1 configured to process the interferometric feedback data from the back-reflected beam and control the distance between the NV diamond 10 and the item 16.
c. An actuator for distance control 15 configured to dynamically adjust the NV diamond's position, based on feedback from processing unit for stand-off distance readout 1, ensuring that the NV diamond's position maintains an optimal lift-off distance for precise measurements.

Preferably, this closed-loop feedback ensures that the sensor head A remains at an ideal proximity to the item 10, thereby optimizing both ODMR-based sensing accuracy and spatial resolution.

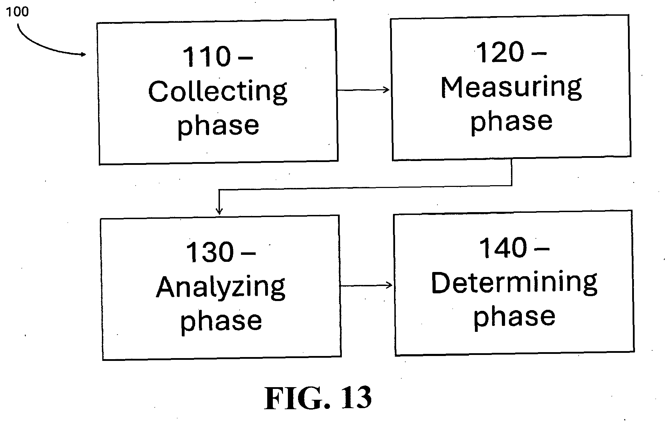

According to another embodiment, and as illustrated by figure 13, the present invention relates also to a computer-implemented method 100 for, preferably simultaneously, determining magnetic field parameters and distances, advantageously using the present invention.

This method 100 comprises preferably at least the following phases:
a. A collecting phase 110;
b. A measuring phase 120;
c. An analyzing phase 130; and
d. A determining phase 140.

Advantageously, the structured phases - from collecting to determining - exhibit a deliberate approach that leverages the photonic interactions within the NV diamond alongside the reflected second light analysis. By sequentially and/or simultaneously executing these phases, the present invention increases efficiency, allowing the present invention to aggregate and process large datasets from the photodetectors effectively.

According to an embodiment, the collecting phase 110 initiates the measurement process by first exciting at least one nitrogen-vacancy center within the diamond using the first light source that preferably emits a specified wavelength, for example in the green spectral range, which effectively stimulates the NV centers to become luminescent, setting the stage for magnetic field detection through photoluminescence; next or at the same time, a second light source, which can be a laser or polychromatic source, illuminates at least part of the item, generating reflected light that carries information about the distance between the sensor head and the item; subsequently or simultaneously, a microwave signal is delivered through the microwave antenna to the diamond, inducing an optically detected magnetic resonance effect in the NV centers that enhances their sensitivity to variations in the surrounding magnetic field; finally, the present invention collects NV photoluminescence produced in response to the first light as well as captures at least a portion of the reflected second light via optical fibers, thereby aggregating crucial data needed for subsequent analysis.

According to an embodiment, in the measuring phase 120, the collected signals are subjected to thorough analysis, beginning with measuring the NV photoluminescence via the first photodetector, which quantifies the fluorescence and generates a photoluminescence signal; simultaneously or previously or subsequently, the fraction of the reflected second light is measured using a second photodetector or a spectrophotometer to produce a distance signal corresponding to the distance between the sensor head and the item; this step is configured to translate the raw optical signals into quantifiable parameters that correlate directly with the magnetic field characteristics and the spatial relationship with the item being measured, laying the groundwork for deeper analysis and understanding of the measurement context.

According to an embodiment, following measurement, the analyzing phase 130 starts with the interpretation of the distance signal, wherein the first processing unit processes the reflected light information to accurately discern the distance between the sensor head and the item, ensuring alignment with expected values; concurrently or previously or subsequently, the second processing unit analyzes the photoluminescence signal to extract detailed magnetic field information, leveraging the data gathered from the NV centers to derive valuable insights about the nature and characteristics of the magnetic field affecting the item; this phase is integral as these analyses convert raw data into actionable intelligence, thereby providing a comprehensive understanding of both magnetic and distance measurements.

According to an embodiment, in the determining phase 140, the present invention consolidates and draws conclusions from the previously analyzed signals, commencing with the first processing unit utilizing the distance signal to definitively determine the spatial separation between the sensor head and the item, ensuring precision in the measurements; concurrently, the second processing unit processes the magnetic field information garnered from the photoluminescence signal to ascertain at least one valuable parameter relating to the magnetic field, which may comprise metrics such as amplitude, norm, frequency, orientation vector, and/or phase; aptly completing this phase yields a robust dataset of measurable variables that encompass both distance and magnetic field characteristics, affording meaningful data interpretation necessary for application in various advanced technological fields.

According to an embodiment, the method 100 can further comprise, after the determining phase, an adjusting phase. Preferably, the adjusting phase comprising adjusting the sensor head position relatively to the item using the actuator based on the value of the parameter of the magnetic field and and/or the determined distance.

According to an embodiment, and as previously described, the present invention is configured to execute a workflow where each previously described components interacts dynamically to achieve high-precision ODMR sensing with integrated lift-off distance measurement:
a. The laser 3, preferably green, illuminates the NV diamond 10 through the objective lens 18.
b. The microwave generation unit excites the NV centers through the microwave antenna 8, initiating the ODMR process.
c. The photoluminescence emitted from the NV centers is collected and filtered by the dichroic mirror 19 and detected by the photodetector 13.
d. the laser beam, preferably green, is reflected from the item surface, creating an interference signal that is detected by the photodetector for local reference 17 to precisely determine the lift-off distance.
e. The processing unit for stand-off distance readout 1 and the processing unit for magnetic field readout 2 analyze the ODMR and interferometric signals, providing real-time feedback to the actuator 15 for dynamic positioning adjustment.

Advantageously, the present invention offers several technical advantages over conventional ODMR sensing systems:
a. The combination of ODMR sensing with interferometric distance feedback enables highly precise and stable measurements.
b. The real-time feedback mechanism continuously adjusts the NV sensor's lift-off distance, ensuring optimal data acquisition.
c. The present invention is suitable for applications in quantum sensing, nanoscale magnetometry, biomedical imaging, and materials characterization.

By integrating high-precision optical and microwave components with an interferometric distance control system, the present invention significantly advances the capabilities of optically detected magnetic resonance-based quantum sensing.

The present invention relates to a novel architecture that combines optically detected magnetic resonance with interferometric lift-off distance measurement. The integration of these two techniques ensures superior measurement precision and robust feedback control. The present invention represents a significant advancement in quantum sensing technology, offering new opportunities for nanoscale magnetic field detection, temperature monitoring, and high-resolution spatial positioning in scientific and industrial applications.

While the first and second embodiment respectively concern a confocal chromatic measurement technique and interferometry measurement technique, both techniques can be combined in a single embodiment.

## Claims

1. A sensor head (A) for measuring a magnetic field and a distance between the sensor head and an item, the sensor head comprising at least:
- An objective (50) comprising a nitrogen-vacancy center doped diamond (40) adapted to produce a fluorescence in response to a first light, wherein the first light is chosen so as to excite the nitrogen-vacancy centers;
- a light-guiding component (41a) configured to guide said first light to said diamond and at least part of the fluorescence collected from the diamond;
wherein the objective (50) is positioned between the light-guiding component (41a) and the item,
and wherein the diamond is designed to receive a second light from the light-guiding component, transmit the second light to the item facing the diamond, and collect at least part of the reflected second light for transmission back to the light-guiding component (41a).

2. The sensor head (A) according to claim 1, further comprising a microwave antenna (44) configured to provide a microwave magnetic field to said diamond.

3. The sensor head (A) according to one of the claim 1 or 2, wherein the second light is a polychromatic light and wherein the diamond acts as a chromatic dispersive optical element, the chromatic dispersion caused by the diamond being sufficient for allowing a confocal chromatic measurement of a distance between the diamond and the item.

4. The sensor head (A) according to one of the claims 1 to 3, comprising a gradient-index lens (61) arranged between the light-guiding component and the diamond.

5. The sensor head (A) according to claim 2, wherein the second light is a laser light and wherein said objective is configured for one among: focusing the second light on the surface of the item; or collimating the second light for illuminating the item.

6. A device for measuring a magnetic field and at least one distance between a sensor head (A) according to any one of the previous claims and an item, the device comprising:
- said sensor head (A) ;
- a first source (42a) of the first light;
- a second source (42b) of the second light;
- said device being configured to inject the first and second lights into the light-guiding component (41a) of the sensor head, said device further comprising:
o a first detector (47a) for detecting red fluorescence produced by the diamond of the sensor head in response to the first light;
o a second detector (47b) for detecting second light reflected by an item under test placed in front of the sensor head (A);
o a signal processor (49) for obtaining a measurement of a magnetic field responsive to the detected red fluorescence and a measurement of a distance between the diamond and the item responsive to the reflected second light.

7. The device according to claim 6, further comprising an actuator (C) responsive to a control signal function of the measured distance, and wherein the signal processor (49) is further configured to apply a feedback loop to the actuator (15) to dynamically adjust the distance between the sensor head and the item under test, based on the measurement of the distance obtained from the reflected second light.

8. The device according to any of the two previous claims, wherein the first light source (42a) is a laser emitting in the green spectral range, and the second light source (42b) is a white light source configured to provide chromatic dispersion-based distance measurement.

9. The device according to any of the three previous claims, wherein the first detector (47a) is a photodetector (13) configured to analyze optically detected magnetic resonance signals from the fluorescence of the nitrogen-vacancy diamond, and wherein the second detector (47b) is a spectrophotometer configured to measure the spectral shift of the back-reflected second light for stand-off distance control.

10. The device according to claim 6, wherein the second light source (42b) is a laser source configured to generate a coherent beam for interferometric detection, and the second detector (47b) is an interferometric photodetector configured to analyze phase shifts in the back-reflected second light to achieve sub-nanometer precision in distance measurement.

11. The device according to any of the five previous claims, wherein the signal processor (49) comprises a first processing unit and a second processing unit, the first processing unit being configured to analyzing a distance signal to obtain the measurement of a distance between the diamond and the item, and the second processing unit being configured to analyze a photoluminescence signal to obtain the measurement of a magnetic field.

12. A computer-implemented method (100) for determining a magnetic field parameter and a distance between a sensor head according to any of the claims 1 to 6 and an item, the method (100) being configured to be executed by the device according to any of the seven previous claims, the method (100) comprising at least:
a. A collecting phase (110) comprising the following steps:
i. Excitation of at least one nitrogen-vacancy center in a diamond (10) using a first source emitting a first light;
ii. Illuminating at least partially the item using a second source emitting a second light;
iii. Delivering a microwave signal via a microwave antenna (8) using a microwave generation unit to induce an optically detected magnetic resonance in the nitrogen-vacancy diamond (10);
iv. Collecting nitrogen-vacancy photoluminescence and at least a fraction of the reflected second light via the optical fiber (9);
b. A measuring phase (120) comprising at least the following steps executed in any order:
i. Measuring the nitrogen-vacancy photoluminescence using at least a first photodetector to get at least one photoluminescence signal;
ii. Measuring the fraction of the reflected second light using a second photodetector or a spectrophotometer to get at least one distance signal related to the distance between the sensor head and the item;
c. An analyzing phase (130) comprising at least the following steps executed in any order:
i. Analyzing the distance signal to get the distance between the sensor head and the item using a first processing unit.
ii. Analyzing the photoluminescence signal to get magnetic field information from the item using a second processing unit.
d. A determining phase (140) comprising at least the following steps executed in any order:
i. Determining the distance between the sensor head and the item from the distance signal using the first processing unit;
ii. Determining at least one value of at least one parameter of the magnetic field from the magnetic field information using the second processing unit.

13. Method (100) according to the previous claim further comprising, after the determining phase, an adjusting phase comprising adjusting the sensor head position relatively to the item using a actuator (15) based on the value of the parameter of the magnetic field and and/or the determined distance.

14. A computer product program for determining, preferably simultaneously, a magnetic field parameter and a distance between a sensor head of a device according to any of the claims 7 to 12 and an item, which, when executed by at least one processing unit, executes the method according to any one of the three previous claims.

15. A non-transitory computer readable medium comprising at least one computer program product according to the previous claim.
